# FASCICULE DE BREVET EUROPEEN

(11) **EP 2 887 358 B1**
(45) Date de publication et mention de la délivrance du brevet: **11.07.2018**
(21) Numéro de dépôt: 14196809.9
(22) Date de dépôt: 08.12.2014
(51) Int. Cl.: G21C 15/00, F16K 1/12, F16K 31/04, F16K 31/06, G21D 1/00, G21C 1/02

(54) **Vanne pour circulation de fluide**
Ventilklappe für Flüssigkeitskreislauf
Valve for fluid circulation

(30) Priorité: 18.12.2013 FR 1362929
(43) Date de publication de la demande: 24.06.2015
(73) Titulaire: COMMISSARIAT À L'ÉNERGIE ATOMIQUE ET AUX ÉNERGIES ALTERNATIVES, 75015 Paris (FR); Reg Technology, 59481 Haubourdin (FR)
(72) Inventeur: Taraud, Pascal, 84120 PERTUIS (FR); Delabergerie, Arnaud, 62400 BETHUNE (FR); Gastaldi, Olivier, 13490 JOUQUES (FR); Pennel, Patrice, 59170 CROIX (FR)
(74) Mandataire: Hautier, Nicolas

(56) Documents cités:
- US-A- 2 289 574
- US-A- 3 871 176
- US-A- 4 452 423
- US-A- 4 789 132
- US-A- 4 948 091
- US-A1- 2010 025 608

## Description

### DOMAINE TECHNIQUE DE L'INVENTION

L'invention concerne de manière générale le domaine des vannes. Elle s'applique de manière particulièrement avantageuse aux vannes pour la circulation de métal liquide, tel que le sodium liquide, porté à une température élevée et pouvant par exemple atteindre 450°C.

L'invention trouve pour domaine d'application privilégié le nucléaire et plus précisément l'exploitation des réacteurs à neutrons rapides à caloporteur sodium.

### ÉTAT DE LA TECHNIQUE

Les réacteurs à caloporteur de 4^{ème} génération tel que le réacteur ASTRID (*Advanced Sodium Technological Reactor for Industrial Demonstration*) utilisent comme caloporteur un métal liquide, généralement du sodium. Ce caloporteur, en plus de présenter une température très élevée, typiquement supérieure à 400°C, est généralement chimiquement très réactif.

Il est donc fondamental d'assurer une étanchéité aussi fiable que possible tout au long du parcours du fluide et notamment au niveau des vannes.

Pour contrôler la circulation de sodium, plusieurs types de vannes ont été développés. Ces vannes sodium prévoient un obturateur configuré pour coopérer avec un siège afin d'empêcher l'écoulement du sodium liquide. Un dispositif de commande présente un volant, motorisé ou manuel, relié par une tige mobile à l'obturateur et dont l'actionnement permet de sélectivement éloigner ou rapprocher l'obturateur du siège.

Afin d'assurer l'étanchéité, un premier type de vanne sodium prévoit un joint sodium solidifié. Dans ce type de vanne sodium, une portion de la vanne au contact de la tige mobile est configurée pour accueillir du sodium liquide et abaisser sa température. Dans cette portion, le sodium solidifie et assure l'étanchéité vers l'extérieur. D'autres organes d'étanchéité tels que des garnitures d'étanchéité sont également prévues.

Ce type de vanne présente notamment pour inconvénient de nécessiter un système complexe de maintien du dispositif d'actionnement et du système d'étanchéité. Le dispositif d'actionnement et le système d'étanchéité forment en effet une masse importante. En outre, cette masse importante est relativement déportée de la tuyauterie ce qui accroit les risques de rupture notamment en cas de séisme. Pour réduire les risques de rupture, des systèmes de maintien complexes et onéreux sont donc aujourd'hui utilisés.

Un deuxième type de vanne sodium prévoit une étanchéité basée sur un soufflet. Dans ce type de vanne sodium, la tige est équipée d'un soufflet formant une barrière pour le passage du sodium liquide.

Cette vanne permet de réduire quelque peu le déport entre la tuyauterie et le dispositif d'actionnement et d'étanchéité, bien que ce déport ne disparaisse pas. En revanche, ce type de vanne implique de nombreuses pièces mécaniques, soumises à l'usure et présente ainsi une fiabilité limitée.

Par ailleurs, dans domaines éloignés de celui des vannes pour sodium liquide, des vannes diverses ont été proposées. Les documents US4948091, US 2010/025608, US4789132, US2289574, US4452423, US3871176 décrivent des solutions variées de vannes.

Il existe donc un besoin consistant à proposer une vanne permettant de réduire voire de supprimer au moins l'un des inconvénients des vannes connues pour le sodium liquide.

La présente invention vise à répondre à ce besoin. Plus précisément, la présente invention a pour objectif de réduire la complexité des systèmes de maintien des dispositifs de commande et d'étanchéité des vannes sodium existantes et/ou d'améliorer la fiabilité de leur étanchéité.

### RÉSUMÉ DE L'INVENTION

Pour atteindre cet objectif, l'invention prévoit une vanne selon la revendication 1 et une utilisation de cette vanne selon la revendication 15. Modes alternatifs sont définis dans les revendications dépendantes. Ainsi, l'obturateur est déplacé grâce à l'induit qui est situé à l'intérieur de l'enceinte. L'effort de commande est donc transmis sans liaison mécanique entre un actionneur externe et l'obturateur. Cela permet de réduire considérablement les contraintes d'étanchéité par rapport aux vannes pour sodium liquide existantes dont l'étanchéité repose sur un joint de sodium solidifié ou un soufflet. En outre, cette structure de vanne comporte un nombre de pièces fortement réduit. Seul un organe translate par rapport au carter. Cet organe comprend en particulier l'induit, la vis solidaire de l'induit et l'obturateur porté par la vis.

La robustesse et la fiabilité de l'étanchéité de la vanne sont ainsi considérablement améliorées par rapport aux vannes existantes pour sodium.

La vanne selon l'invention présente en outre d'autres avantages.

Notamment, le dispositif de commande de la position de l'obturateur est disposé à proximité immédiate de l'enceinte en ce qui concerne l'inducteur et à l'intérieur même de l'enceinte en ce qui concerne l'induit. L'invention permet ainsi de réduire le déport du dispositif de commande. Pour rappel, les vannes pour sodium existantes dont l'étanchéité repose sur un joint de sodium solidifié ou sur un soufflet nécessitent une tige de transmission d'effort entre l'obturateur et un volant manuel ou motorisé. Par ailleurs, en dépit des systèmes de maintien habituellement complexes mis en place, le déport de masse accroît inévitablement les risques de rupture en cas de séisme. L'invention apporte donc un avantage significatif pour les applications dans lesquelles la sécurité est un enjeu fondamental tel que le nucléaire.

Par ailleurs, en prévoyant un écrou porté par le carter et une vis creuse à l'intérieur de laquelle circule le fluide, la vanne selon l'invention permet de réduire significativement les pertes de charges.

En outre elle autorise des débits élevés pour un encombrement limité par rapport aux vannes existantes pour métal liquide. Typiquement, pour une application avec du sodium liquide, la vanne selon l'invention permet une vitesse du fluide pouvant dépasser 10 mètres par seconde. Elle est ainsi parfaitement adaptée aux réacteurs à neutrons rapides à caloporteur sodium.

En outre, en prévoyant un induit solidaire de la vis, l'invention permet d'éviter les risques de grippage entre induit et vis par rapport à une solution dans laquelle l'induit et la vis ne seraient pas solidaires.

L'invention présente par ailleurs un coût de revient significativement réduit par rapport aux vannes sodium existantes.
- Selon un exemple, l'inducteur est fixe par rapport au carter. De préférence, l'inducteur est solidaire du carter. Ce mode de réalisation sera privilégié lorsque l'inducteur comprend au moins une bobine. Alternativement l'inducteur est entrainé en rotation s'il comprend uniquement des aimants permanents.
- Selon un exemple, la vanne est configurée de manière à ce que la vis soit noyée dans le fluide.
- Selon un exemple, la vanne est configurée de manière à ce que l'écoulement principal du fluide ait lieu par l'intérieur de la vis. De préférence, elle est configurée de manière à ce que tout le fluide s'écoule par l'intérieur de la vis.
- Selon un exemple, le carter présente une paroi formant l'enceinte. Avantageusement, l'inducteur et l'induit sont disposés de part et d'autre de la paroi formant l'enceinte.
- Selon un exemple, l'écrou est porté par une face interne de la paroi.
- Selon un exemple, le carter présente une paroi cylindrique.
- Selon un exemple, le filetage de l'écrou est porté par la paroi cylindrique.
- Selon un exemple, l'inducteur est situé à l'extérieur de l'enceinte. Cela permet de supprimer toute contrainte d'étanchéité du liquide par rapport à l'inducteur. De préférence, l'inducteur est situé sur une face externe de la paroi du carter.
- Selon un exemple, la vanne est configurée de manière à ce que tout le fluide s'écoule par l'intérieur de la vis. De préférence, la vis présente une paroi intérieure qui forme en partie au moins dans une chambre d'écoulement de manière à ce que tout le fluide s'écoule à l'intérieur de la vis. De préférence, la vis présente une paroi intérieure qui délimite entièrement, sur au moins une portion longitudinale de l'enceinte, la chambre d'écoulement.
- Selon un exemple, l'enceinte est étanche. Le fluide ne peut pas s'échapper de l'enceinte à l'exception des entrée et sortie. Il n'est pas en contact avec l'atmosphère.
- Selon un exemple, la vis présente une face extérieure qui est disposée au regard de la face interne de la paroi du carter et qui porte un filetage configuré pour coopérer avec l'écrou.
- Selon un exemple, la paroi du carter présente une face interne dont une portion au moins est cylindrique et la vis présente une paroi intérieure dont une portion au moins est cylindrique et dans laquelle le rapport du diamètre de la paroi intérieure de la vis sur le diamètre de la face interne de la paroi du carter au niveau de la coopération entre la vis et l'écrou, et plus précisément au niveau du filetage de la vis, est supérieur à 0.6 et de préférence supérieur à 0.7 et de préférence supérieur à 0.85. Typiquement, il est compris entre 0.7 et 0.9. Cela permet d'autoriser un débit élevé pour un encombrement limité.
- Selon un exemple, la coopération entre la vis et l'écrou forme une liaison de type vis à billes. Cela permet de limiter le grippage et l'usure des pièces améliorant de ce fait la robustesse et la fiabilité de la vanne.
- Selon un exemple, la vis à billes est configurée pour être irréversible, de manière à ce qu'une force de poussée appliquée sur l'obturateur, au moins dans le sens tendant à éloigner l'obturateur du siège, ne permette pas d'entrainer la vis en rotation dans ce sens. Ainsi, même si la pression du fluide est grande et même si aucun couple n'est appliqué par l'inducteur sur l'induit, la vis ne peut pas être entrainée en rotation et n'éloigne donc pas l'obturateur de son siège. Seule une rotation appliquée à la vis permet de faire cela. Cette caractéristique permet d'améliorer encore plus la sécurité et la fiabilité de la vanne puisque même en cas de défaillance du dispositif de commande, la vanne conservera sa position fermée. Cette amélioration de la sécurité est particulièrement avantageuse lorsque la vanne est intégrée dans un circuit de réacteur nucléaire.
- Selon un exemple, le carter forme une pièce monolithique. Il n'est pas formé de pièces solidarisées entre elles par des vis et des brides. Cela permet d'accroitre considérablement la robustesse et la fiabilité de la vanne, ce qui constitue un avantage considérable dès lors que les fuites de fluide peuvent engendrer des dommages graves, ce qui est le cas avec le sodium liquide.
- Selon un exemple, le carter est en métal.
- Selon un exemple, il est formé uniquement de pièces soudées les unes aux autres.
- Selon un exemple, la vis est en métal.
- Selon un exemple, l'obturateur est articulé en rotation libre sur la vis au moins autour de l'axe de translation de la vis. Cela permet de réduire voire de supprimer la friction entre l'obturateur et le siège lors de la fermeture de la vanne. L'usure de l'obturateur et du siège sont ainsi considérablement limitées.
- Selon un exemple, la liaison mécanique entre d'une part le carter et d'autre par la vis est assurée uniquement par la coopération entre la vis et l'écrou. Ainsi, il n'y pas de roulement entre l'organe mobile et le carter, autres que d'éventuelles billes d'un système vis à bille formant la coopération entre la vis et l'écrou. L'invention supprime ainsi toutes les contraintes d'étanchéité que l'on pourrait rencontrer entre les roulements et le fluide.
- Selon un exemple, la vanne comprend une enveloppe solidaire de la vis et qui coopère avec la vis pour former un logement étanche destiné à recevoir l'induit. Ainsi, l'induit est disposé dans un logement étanche. L'enveloppe et la vis étant solidaires l'une de l'autre, l'étanchéité entre ces deux pièces est une étanchéité statique, ce qui simplifie encore la vanne et accroit sa fiabilité. Dans ce mode de réalisation privilégié, la vanne ne nécessite aucun joint d'étanchéité à l'intérieur de l'enceinte. La seule étanchéité est celle inévitablement nécessaire entre la vanne et les tuyauteries destinées à être connectées sur les entrée et sortie de la vanne. Ainsi, l'étanchéité de la vanne est assurée uniquement par l'enceinte.
- Selon un exemple, l'induit est placé au regard de la paroi interne du carter, et des joints au contact de la paroi interne du carter et de la vis ou de l'induit sont positionnés de part et d'autre de l'induit selon la direction de translation de la vis et sont configurés pour empêcher le fluide de parvenir jusqu'à l'induit.
- Selon un exemple, une couche de protection solidaire de l'induit recouvre ce dernier. Elle est disposée entre l'induit et la face interne du carter.
- Selon un exemple, le carter s'étend principalement selon une direction longitudinale correspondant à la direction de translation de la vis et au moins l'une parmi l'entrée et la sortie est conformée de manière à former un point bas de l'enceinte au moins pour une position de la vanne dans laquelle sa direction longitudinale est disposée horizontalement. Ainsi, même en position horizontale, la vanne ne présente pas de point de rétention de fluide. Cela est particulièrement avantageux, pour vidanger la vanne ou pour éviter que le fluide ne subisse des transformations préjudiciables au bon fonctionnement du dispositif, l'invention permet ainsi d'éviter que du sodium liquide en rétention ne se transforme en soude après solidification.
- Selon un exemple, le carter s'étend principalement selon une direction longitudinale correspondant à la direction de translation de la vis et présente au moins l'une parmi l'entrée et la sortie qui est désaxée par rapport à la direction de translation de la vis.
- L'entrainement de la vis s'effectue uniquement par la force magnétique du dispositif de commande.
- Le dispositif de commande forme un moteur électrique dont le rotor est solidaire de la vis.
- Selon un exemple, le dispositif de commande comprend des aimants permanents. Cela permet de réduire l'encombrement de la vanne. De manière combinée ou alternative, le dispositif de commande comprend des bobines. Cela permet de réduire le coût de la vanne.

Un autre aspect de la présente invention concerne un système de contrôle de la circulation d'un métal liquide comprenant une canalisation métallique et une vanne selon l'invention, le carter et la vis étant en métal et la vanne étant soudée à la canalisation.

Un autre aspect de la présente invention concerne une utilisation de la vanne selon l'invention pour contrôler un fluide présentant une température supérieure ou égale à 350°C et de préférence supérieure ou égale à 400°C. De préférence, le fluide est un métal à l'état liquide. De préférence, le liquide est du sodium liquide.

Les autres objets, caractéristiques et avantages de la présente invention apparaîtront à l'examen de la description suivante et des dessins d'accompagnement. Il est entendu que d'autres avantages peuvent être incorporés.

### BRÈVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :
La FIGURE 1 est une vue en coupe longitudinale d'une vanne selon un exemple non limitatif de l'invention, la vanne étant en position ouverte.
La FIGURE 2 est une vue en coupe longitudinale de la vanne illustrée en figure 1, la vanne étant en position fermée.
La FIGURE 3 est une vue en coupe radiale d'une vanne selon un autre exemple non limitatif de l'invention, la coupe étant prise au niveau de l'inducteur et de l'induit.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier les dimensions et épaisseurs relatives des différentes pièces, parois et organes ne sont pas représentatives de la réalité.

### DESCRIPTION DÉTAILLÉE DE L'INVENTION

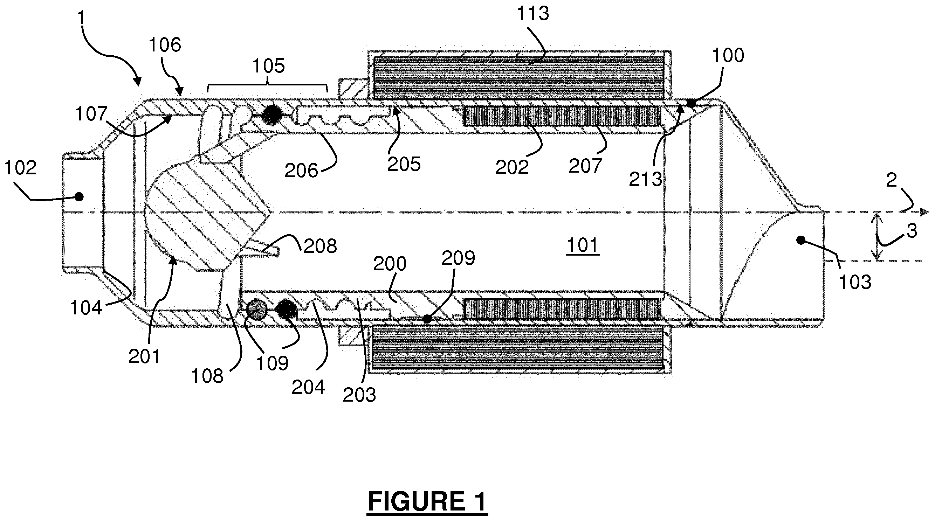

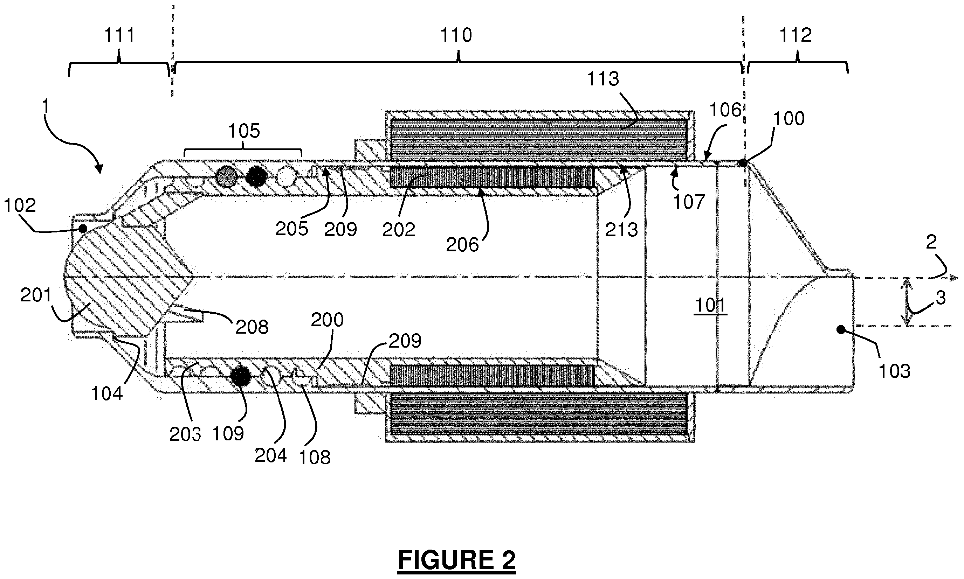

En référence aux **figures 1** **et** **2**, un exemple non limitatif de vanne 1 selon l'invention va maintenant être décrit.

La vanne 1 comprend un carter 100 formant une chemise externe et qui définit une enceinte 101 à l'intérieur de laquelle le fluide est destiné à s'écouler. Le carter 100 présente sur cet exemple non limitatif, une entrée 102 et une sortie 103. A l'exception de l'entrée 102 et de la sortie 103, l'enceinte 101 est étanche. Le carter 100, au niveau de l'entrée 102 et de la sortie 103, forme des extrémités à souder destinées à coopérer avec un élément de tuyauterie pour raccorder fluidiquement la vanne 1 à un réseau fluidique ou à des brides. Dans le cadre d'une application aux réacteurs nucléaires à caloporteur sodium, les extrémités sont de préférence soudées sur des canalisations du circuit sodium.

La vanne 1 comprend également un organe mobile 200 à l'intérieur du carter 100. Avantageusement, cet organe mobile 200 est entièrement logé à l'intérieur de l'enceinte 101. Il est mobile en translation à l'intérieur du carter 100. De préférence, l'enceinte 101 s'étend principalement selon une direction longitudinale 2, correspondant à l'axe de translation référencé 2 de l'organe mobile 200. L'organe mobile 200 présente un obturateur 201 destiné à coopérer avec une zone complémentaire formant siège 104 et solidaire du carter 100. De préférence, le siège 104 est formé par la paroi du carter 100 qui définit l'enceinte 101. Lorsque l'obturateur 201 est appliqué contre le siège 104, il obstrue le passage du fluide et lorsqu'il est éloigné du siège 104, il autorise l'écoulement du fluide. La position de l'obturateur 201 par rapport au siège 104 permet ainsi de contrôler l'écoulement du fluide.

Sur l'exemple non limitatif illustré, le siège 104 est disposé à proximité de l'entrée 102. Un déplacement de l'organe mobile 200 dans le sens de la flèche illustrée en figures 1 et 2 (c'est-à-dire un déplacement allant depuis l'entrée 102 vers la sortie 103) provoque l'éloignement de l'obturateur 201 par rapport au siège 104 pour atteindre la configuration d'ouverture illustrée en figure 1. A l'inverse, un déplacement de l'obturateur 201 dans le sens inverse de la flèche (c'est-à-dire un déplacement depuis la sortie 103 vers l'entrée 102) provoque le rapprochement de l'obturateur 201 par rapport au siège 104 pour atteindre la configuration de fermeture illustrée en figure 2.

L'organe mobile 200 comporte, ou est formé par, une vis 203. Cette vis 203 est configurée pour coopérer avec une surface complémentaire solidaire du carter 100. De manière préférée, la vis 203 présente une face extérieure 205 portant un filetage 204 conformé pour coopérer avec un filetage complémentaire 108 porté par une face interne 107 d'une paroi du carter 100. Selon un mode de réalisation particulier, les filetages 108 et 204 sont en contact direct avec le fluide.

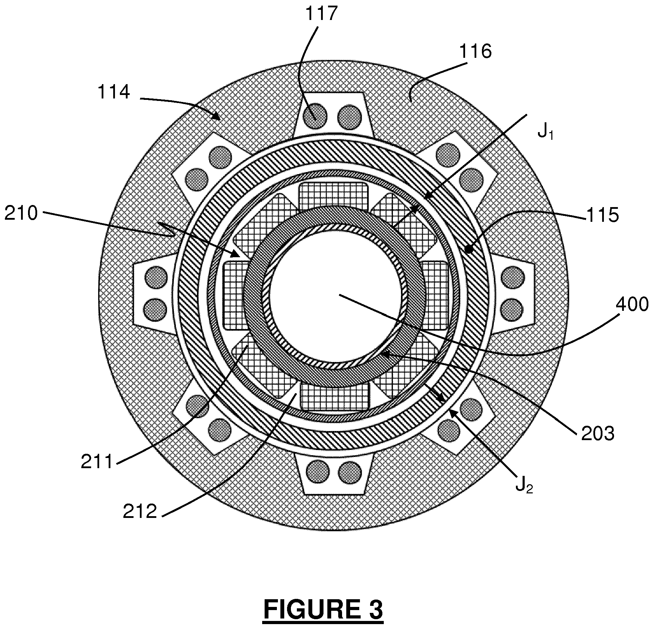

L'organe mobile 200 forme ainsi avec le carter 100 une liaison vis/écrou. L'axe de translation et de rotation de cette liaison est l'axe 2 illustré sur les figures 2 et 3. De préférence, cette liaison vis/écrou est de type vis à billes 109 ce qui permet de réduire les risque de grippage. La rotation dans un premier sens de la vis 203 éloigne donc l'obturateur 201 du siège 104 et la rotation de la vis 203 dans un deuxième sens rapproche l'obturateur 201 du siège 104. La vis 203 est commandée par un dispositif de commande magnétique. Un inducteur 113 entraîne magnétiquement un induit 202 solidaire de l'organe mobile 200. Selon un premier mode de réalisation, préféré et illustré sur les figures, l'induit 202 et l'organe mobile 200 forment des pièces distinctes fixées l'une sur l'autre. Selon un mode de réalisation alternatif, l'induit 202 est formé par la vis 203. Ainsi dans ce mode de réalisation, le ou les matériaux de cette dernière sont sélectionnés pour que la vis 203 fasse office d'induit. Ainsi, vis et induit forment une pièce monolithique.

En fonctionnement, l'induit 202 se situe et évolue à l'intérieur de l'enceinte 101. Avantageusement, l'inducteur 113 est quant à lui disposé à l'extérieur du carter 100, réduisant ainsi les contraintes d'étanchéité.

De manière plus précise, l'inducteur 113 et l'induit 202 sont disposés de part et d'autre de la paroi formant l'enceinte 101 à l'intérieur de laquelle le fluide s'écoule. Selon un mode de réalisation, le dispositif de commande forme ainsi un moteur électrique.

Typiquement au niveau de l'inducteur 113 au moins, la face externe 106 de la paroi est cylindrique et l'inducteur 113 entoure cette paroi. De préférence, la face interne 107 de la paroi est également cylindrique et entoure l'induit 202 avec un jeu de fonctionnement très faible de manière à permettre la rotation de l'induit 202 à l'intérieur de la paroi formant l'enceinte 101. Le dispositif de commande entraînant le déplacement de l'obturateur 201 est donc particulièrement compact. Il ne nécessite pas de système de maintien complexe. En outre, il réduit considérablement l'éloignement le report de masse voire ne présente pas de masse éloignée par rapport à la tuyauterie. L'invention permet ainsi de considérablement simplifier la vanne 1 et d'améliorer sa fiabilité ainsi que la sécurité en cas de choc important ou de tremblement de terre.

Dans un exemple non représenté, l'induit 202 est porté par l'organe mobile 200 en étant recouvert par une enveloppe qui sépare l'induit 202 du fluide. Préférentiellement, l'organe mobile 200 comprend un logement 207 configuré pour accueillir l'induit 202 et l'enveloppe permet de définir un volume fermé et étanche à l'intérieur du logement 207. Cette étanchéité est statique, puisqu'en fonctionnement l'enveloppe est solidaire de l'organe mobile 200. L'étanchéité de l'induit 202 est donc assurée de manière particulièrement simple et efficace.

Dans un autre exemple, l'induit 202 est encapsulé dans une couche de protection. Il est recouvert par une couche de protection qui l'isole du fluide. De préférence, cette couche de protection est un film d'acier, habituellement désigné en anglais « liner ».

Dans un autre exemple, tel que celui illustré en figures 1 et 2, l'induit 202 est disposé directement au regard de la face interne 107 de la paroi du carter 100. Afin de protéger cet induit, il peut être encapsulé dans une couche de protection, de la même manière que le mode précédant. Alternativement, des joints peuvent être disposés entre l'organe mobile 200 et la face interne 107 de la paroi du carter 100 en étant répartis de part et d'autre de l'induit 202 selon l'axe de translation de la vis 203. De préférence, les joints sont logés dans les cavités 209. Selon l'invention, l'organe mobile 200 présente un passage intérieur pour l'écoulement du fluide. Ainsi, la vis 203 est creuse. Préférentiellement, tout le fluide s'écoule par ce passage. Selon un mode de réalisation particulièrement avantageux, l'organe mobile 200 présente sur une portion longitudinale au moins, une forme sensiblement cylindrique. Cette portion comprend le filetage externe 204 de la vis 203 et l'induit 202. Cette portion est creuse et présente une face intérieure 206 qui délimite, sur une portion longitudinale de la vanne 1, la chambre d'écoulement.

Il convient de noter que quand bien même une partie du fluide passerait entre la face interne 107 de la paroi du carter 100 et la face externe 213 de l'organe mobile 200, cela ne provoquerait pas de fuite de fluide hors du carter 100.

Selon un mode de réalisation privilégié, l'organe mobile 200 forme avec la vis 203 une seule et même pièce.

Selon un mode de réalisation privilégié, la paroi intérieure de la vis 203 au niveau de son filetage 204 pour coopérer avec l'écrou 105 définit une section de passage pour le fluide. De préférence, tout le fluide passe par cette section. Avantageusement, le rapport du diamètre de la paroi intérieure de la vis 203 sur le diamètre de la face interne 107 de la paroi du carter 100 au niveau de la coopération entre la vis 203 et l'écrou 105, et plus précisément au niveau du filetage 204 de la vis 203, est supérieur à 0.6 et de préférence supérieur à 0.7 et de préférence supérieur à 0.85. Typiquement, il est compris entre 0.7 et 0.9. Cela permet d'autoriser un débit élevé pour un encombrement limité. Cela permet avantageusement de limiter les pertes de charge.

Typiquement, dans le cadre d'un circuit sodium pour réacteur nucléaire, au niveau du filetage 108 porté par l'écrou 105, le diamètre de la face interne 107 de la paroi du carter 100 peut être supérieur à plusieurs dizaines de centimètres et celui de la paroi intérieure peut aussi être supérieur à plusieurs dizaines de centimètres. La vitesse du sodium peut atteindre un maximum de 10 m/s.

De préférence, le guidage en rotation de l'organe mobile 200 dans le carter 100 est assuré par le couple vis 203 écrou 105 uniquement. Ainsi, la vanne 1 ne nécessite pas de roulement à billes à l'intérieur du carter 100. Cela est particulièrement avantageux pour les applications nucléaires puisque la présence de sodium liquide avec les roulements à billes pourrait complexifier significativement la vanne 1.

De préférence, le guidage en translation de l'organe mobile 200 dans le carter 100 est assuré uniquement par la coopération entre l'écrou 105 et la vis 203. Eventuellement, des portées ajustées de manière adéquate peuvent être prévues pour améliorer le guidage en translation.

De manière particulièrement avantageuse, la liaison vis à billes est dimensionnée de manière à être irréversible. L'invention permet ainsi d'assurer un maintien passif de l'obturateur 201 contre le siège 104, améliorant de ce fait considérablement la sécurité de la vanne 1 même en cas de défaillance du dispositif de commande. Par exemple, pour un diamètre intermédiaire du filetage interne 204 et du filetage externe 108 de 98 mm et pour un pas de vis de 15mm, on choisira un angle d'hélice de 2.8.

De préférence, la sortie 103 et/ou l'entrée 102 empêche toute rétention de fluide dans l'enceinte 101. Par exemple comme illustré sur les figures 1 et 2, la sortie 103 est désaxée par rapport à l'axe de translation. Le désaxage est référencé 3 sur les figures. De préférence, la sortie 103 constitue un point bas pour la vanne 1 lorsque sa direction longitudinale 2 est disposée horizontale. Cela est particulièrement avantageux pour vidanger la vanne 1. L'avantage est encore plus manifeste lorsque le fluide est du sodium et que la solidification dans des poches de rétention formerait de la soude.

Comme illustré sur la figure 2, la face interne 107 de la paroi du carter 100 présente une portion centrale 110 cylindrique, de préférence de diamètre constant, ainsi que deux portions d'extrémité 111, 112. Une première portion d'extrémité 111 est tronconique et relie la portion centrale 110 à la bride centrée sur l'axe de rotation de la vis 203. Une autre portion d'extrémité 112 est partiellement tronconique et relie la portion centrale 110 à la bride qui est désaxée par rapport à l'axe de rotation de la vis 203.

Selon un autre exemple, l'entrée 102 est désaxée et constitue un point bas évitant les poches de rétention.

Selon un autre exemple, l'entrée 102 et la sortie 103 sont coaxiales entre elles et disposées coaxialement à l'axe de translation.

Préférentiellement, la vis 203 forme une pièce monolithique qui comporte au moins le filetage interne 204 et la zone de réception de l'induit 202. Selon un mode de réalisation avantageux, la vis 203 est solidaire d'un support 208 d'obturateur 201 qui est par exemple soudé sur la vis 203 ou qui forme avec cette dernière une pièce monolithique.

Le support 208 d'obturateur 201 comporte des nervures reliant la vis 203 à l'obturateur 201 et des ouvertures pour le passage du fluide. Le siège 104 et l'obturateur 201 sont centrés sur l'axe de rotation de la vis 203. De préférence, l'obturateur 201 présente une portion sphérique destinée à s'appuyer contre le siège 104 qui présente une portion circulaire ou tronconique de manière à ce que la fermeture de la vanne 1 s'effectue par un contact circulaire.

Selon un autre exemple, l'obturateur 201 est monté en rotation libre par rapport à la vis 203 au moins autour de l'axe de rotation de la vis 203. Cela permet de supprimer la friction entre l'obturateur 201 et le siège 104 en transférant le mouvement de rotation entre l'obturateur 201 et la vis 203 limitant de ce fait l'usure du siège 104 et de l'obturateur 201. De préférence, le support 208 d'obturateur 201 est solidaire de la vis 203 et reçoit l'obturateur 201 en liaison pivot simple autour de l'axe de rotation de la vis 203.

De manière préférée, l'organe mobile 200 constitué de la vis 203 et du support 208 d'obturateur 201 est entièrement en métal. Il peut être monolithique ou formé par des pièces soudées. De préférence, l'obturateur 201 est également en métal.

Dans un autre exemple, l'obturateur 201 est fixe par rapport à la vis 203 et forme avec cette dernière et le support 208 d'obturateur 201 une pièce monolithique.

De manière préférée, la paroi du carter 100 définissant l'enceinte 101 forme une seule pièce. Elle est de préférence en métal. Elle est de préférence obtenue par soudage de plusieurs pièces. De préférence, l'ensemble du carter 100 à l'exception éventuellement de l'inducteur 113 et du dispositif d'alimentation électrique de ce dernier, dans le cas où l'inducteur 113 n'est pas un aimant permanent, est tout en métal.

Ainsi, la vanne 1 peut être réalisée entièrement en métal. Elle est ainsi parfaitement adaptée aux liquides chimiques agressifs et/ou à des liquides portés à une très haute température comme par exemple le caloporteur sodium utilisé dans les réacteurs nucléaires de 4^{ème} génération. Selon un mode de réalisation privilégié, la vanne 1 selon l'invention ne comporte pas des joints 300 d'étanchéité. Préférentiellement, le carter 100, respectivement la vis 203 sont entièrement soudés ce qui accroît encore la robustesse et la fiabilité de l'ensemble.

Selon un autre exemple, l'entraînement en rotation de la vis 203 par le dispositif de commande s'effectue par des aimants permanents. Cela permet de réduire l'encombrement de la vanne 1.

Selon un exemple alternatif, le dispositif de commande comprend un moteur muni de bobines. Cette alternative présente pour avantage d'être moins coûteuse que des aimants permanents.

La **figure 3** illustre un autre mode de réalisation comprenant des aimants et des bobines. Dans ce mode de réalisation la vis 203 entoure le fluide. L'induit 202 formant le rotor 210 entoure la vis 203. Il comprend des aimants 211 et une culasse magnétique 212. La paroi du carter 100 forme une tuyauterie 115 entourant le rotor 210 en étant distant de ce dernier d'un jeu J1. L'inducteur 113 forme le stator 114 et entoure la tuyauterie 115. Le stator comprend des bobines 116 et une culasse magnétique 117. De préférence un jeu, référencé J2, sépare le stator 114 de la tuyauterie 115.

De manière particulièrement avantageuse, on peut prévoir un dispositif d'actionnement manuel de l'inducteur 113 et/ou un inducteur additionnel actionnable manuellement pour autoriser le déplacement de la vis 203 de manière manuelle. Cela permet de contrôler la position de l'obturateur 201 même en cas de défaillance de l'inducteur 113.

La vanne 1 selon l'invention s'avère donc particulièrement avantageuse dans le domaine des réacteurs nucléaires, plus précisément dans le circuit sodium d'un réacteur à neutrons rapides à caloporteur sodium.

Au vu de la description qui précède, il apparaît clairement que la vanne 1 selon l'invention offre une robustesse accrue et une étanchéité considérablement améliorée par rapport aux vannes 1 existantes. En outre, elle permet de limiter les pertes de charge et d'offrir un débit élevé tout en conservant un encombrement réduit. Sa conception permet une fabrication tout métal ce qui accroît encore sa robustesse et sa fiabilité. Elle permet en outre une vidange facilitée et réduit les risques de rétention involontaire de fluide. Son coût de revient est relativement faible.

Bien que particulièrement avantageuse pour contrôler du sodium liquide, la vanne selon l'invention ne se limite pas la régulation de métal liquide ou à la régulation de liquide porté à des températures supérieures à 300°C.

L'invention n'est pas limitée aux modes de réalisations précédemment décrits et s'étend à tous les modes de réalisation couverts par les revendications.

**REFERENCES**

| | | | |
|---|---|---|---|
| 1. | Vanne | | |
| 2. | Direction longitudinale | | |
| 3. | Désaxage | | |
| | | | |
| 100. | Carter | 200. | Organe mobile |
| 101. | Enceinte étanche | 201. | Obturateur |
| 102. | Entrée | 202. | Induit |
| 103. | Sortie | 203. | Vis |
| 104. | Siège | 204. | Filetage interne |
| 105. | Ecrou | 205. | Face extérieure de la vis |
| 106. | Face externe | 206. | Face intérieure |
| 107. | Face interne | 207. | Logement |
| 108. | Filetage externe | 208. | Support d'obturateur |
| 109. | Bille | 209. | Cavités |
| 110. | Portion cylindrique | 210. | Rotor |
| 111. | Paroi tronconique | 211. | Aimant |
| 112. | Paroi partiellement tronconique | 212. | Culasse |
| 113. | Inducteur | 213. | Face interne de l'organe mobile |
| 114. | Stator | | |
| 115. | Tuyauterie | | |
| 116. | Bobines | | |
| 117. | Culasse | | |

## Revendications

1. Vanne (1) comprenant :
- un carter (100) formant une enceinte (101) à l'intérieur de laquelle un fluide est destiné à s'écouler et présentant au moins une entrée (102) et au moins une sortie (103) du fluide,
- un obturateur (201) configuré pour coopérer avec un siège (104) solidaire du carter (100) pour fermer au moins l'entrée (102) ou au moins la sortie (103) du fluide,
- un dispositif de commande de la position de l'obturateur (201) par rapport au siège (104),
dans laquelle:
- le dispositif de commande comporte au moins un inducteur (113) et au moins un induit (202) couplés magnétiquement et configurés pour que l'inducteur (113) entraine l'induit (202) en rotation de manière à provoquer sélectivement le rapprochement ou l'éloignement de l'obturateur (201) par rapport au siège (104),
- l'induit (202) est situé à l'intérieur de l'enceinte (101) et est fixe par rapport à une vis (203) portant l'obturateur (201), la vis (203) étant configurée pour coopérer avec un écrou (105) solidaire du carter (100) de manière à transformer une rotation de l'induit (202) en une translation de l'obturateur (201),
- la vis (203) est creuse et
**caractérisée en ce que** la vanne (1) est configurée de manière à ce que l'écoulement principal du fluide ait lieu par l'intérieur de la vis (203).

2. Vanne (1) selon la revendication précédente, configurée de manière à ce que tout le fluide s'écoule par l'intérieur de la vis (203).

3. Vanne (1) selon l'une quelconque des revendications précédentes, dans laquelle le carter (100) présente une paroi formant l'enceinte (101), dans laquelle l'inducteur (113) et l'induit (202) sont disposés de part et d'autre de la paroi et dans laquelle l'écrou (105) est porté par une face interne (107) de la paroi.

4. Vanne (1) selon l'une quelconque des revendications précédentes, dans laquelle la paroi du carter (100) présente une face interne (107) dont une portion au moins est cylindrique et la vis (203) présente une paroi intérieure dont une portion au moins est cylindrique et dans laquelle le rapport du diamètre de la paroi intérieure de la vis (203) sur le diamètre de la face interne (107) de la paroi du carter (100) au niveau de la coopération entre la vis (203) et l'écrou (105) est supérieur à 0.6 et de préférence supérieur à 0.85.

5. Vanne (1) selon l'une quelconque des revendications précédentes, dans laquelle la coopération entre la vis (203) et l'écrou (105) forme une liaison de type vis à billes et dans laquelle, de préférence, la vis à billes est configurée pour être irréversible, de manière à ce qu'une force de poussée appliquée sur l'obturateur (201), au moins dans le sens tendant à éloigner l'obturateur (201) du siège (104), ne permette pas d'entrainer la vis (203) en rotation.

6. Vanne (1) selon l'une quelconque des revendications précédentes, dans laquelle le carter (100) forme une pièce monolithique et dans laquelle, de préférence, le carter (100) et la vis (203) sont en métal.

7. Vanne (1) selon l'une quelconque des revendications précédentes, dans laquelle l'obturateur (201) est articulé en rotation libre sur la vis (203) au moins autour de l'axe de translation de la vis (203).

8. Vanne (1) selon l'une quelconque des revendications précédentes, dans laquelle la liaison mécanique entre d'une part le carter (100) et d'autre par la vis (203) est assurée uniquement par la coopération entre la vis (203) et l'écrou (105).

9. Vanne (1) selon l'une quelconque des revendications précédentes, comprenant une enveloppe solidaire de la vis (203) et coopérant avec la vis (203) pour former un logement (207) étanche destiné à recevoir l'induit (202).

10. Vanne (1) selon l'une quelconque des revendications 1 à 8, dans laquelle l'induit (202) et la vis (203) forment une pièce monolithique.

11. Vanne (1) selon l'une quelconque des revendications précédentes, dans laquelle l'enceinte (101) s'étend principalement selon une direction longitudinale (2) correspondant à la direction de translation de la vis (203) et au moins l'une parmi l'entrée (102) et la sortie (103) est conformée de manière à former un point bas de l'enceinte (101) au moins pour une position de la vanne (1) dans laquelle sa direction longitudinale (2) est disposée horizontalement.

12. Vanne (1) selon l'une quelconque des revendications 1 à 11, dans laquelle le carter (100) s'étend principalement selon une direction longitudinale (2) correspondant à la direction de translation de la vis (203) et présente au moins l'une parmi l'entrée (102) et la sortie (103) qui est désaxée par rapport à la direction de translation de la vis (203).

13. Vanne (1) selon l'une quelconque des revendications précédentes, dans laquelle :
- le dispositif de commande comprend des aimants permanents et/ou
- le dispositif de commande comprend des bobines, l'inducteur (113) étant, de préférence, fixe par rapport au carter (100).

14. Système de régulation de la circulation d'un métal liquide comprenant une canalisation métallique et une vanne (1) selon l'une quelconque des revendications précédentes dans laquelle le carter (100) et la vis (203) sont en métal, la vanne (1) étant soudée à la canalisation.

15. Utilisation de la vanne (1) selon l'une quelconque des revendications 1 à 13 pour réguler la circulation d'un fluide présentant une température supérieure ou égale à 350°C et de préférence supérieure ou égale à 400°C.

16. Utilisation de la vanne (1) selon la revendication précédente pour contrôler la circulation de sodium liquide destiné à assurer le transfert de chaleur dans un circuit de réacteur nucléaire à caloporteur sodium.

## Patentansprüche

1. Ventil (1), umfassend:
- ein Gehäuse (100), das ein Gefäß (101) bildet, in dessen Innerem ein Fluid zu strömen bestimmt ist, und das mindestens einen Einlass (102) und mindestens einen Auslass (103) des Fluides aufweist,
- einen Verschluss (201), der dafür eingerichtet ist, mit einem Sitz (104), der fest mit dem Gehäuse (100) verbunden ist, zusammenzuwirken, um mindestens den Einlass (102) oder mindestens den Auslass (103) des Fluids zu verschließen,
- eine Vorrichtung zum Steuern der Stellung des Verschlusses (201) in Bezug auf den Sitz (104),
wobei:
- die Steuervorrichtung mindestens einen Induktor (113) und mindestens einen Anker (202) umfasst, die magnetisch gekoppelt und so eingerichtet sind, dass der Induktor (113) den Anker (202) in Drehung versetzt, um selektiv das Annähern oder das Entfernen des Verschlusses (201) in Bezug auf den Sitz (104) zu bewirken,
- der Anker (202) im Inneren des Gefäßes (101) liegt und in Bezug auf eine Spindel (203), die den Verschluss (201) trägt, fest ist, wobei die Spindel (203) dafür eingerichtet ist, mit einer Mutter (105), die fest mit dem Gehäuse (100) verbunden ist, zusammenzuwirken, um eine Drehung des Ankers (202) in eine Translation des Verschlusses (201) umzuwandeln,
- die Spindel (203) hohl ist, und
**dadurch gekennzeichnet, dass** das Ventil (1) derart eingerichtet ist, dass die Hauptströmung des Fluids durch das Innere der Spindel (203) stattfindet.

2. Ventil (1) gemäß dem vorstehenden Anspruch, das derart eingerichtet ist, dass das gesamte Fluid durch das Innere der Spindel (203) strömt.

3. Ventil (1) gemäß einem der vorstehenden Ansprüche, wobei das Gehäuse (100) eine Wand aufweist, die das Gefäß (101) bildet, wobei der Induktor (113) und der Anker (202) auf beiden Seiten der Wand angeordnet sind und wobei die Mutter (105) von einer Innenfläche (107) der Wand getragen wird.

4. Ventil (1) gemäß einem der vorstehenden Ansprüche, wobei die Wand des Gehäuses (100) eine Innenfläche (107) aufweist, von der mindestens ein Abschnitt zylindrisch ist, und die Spindel (203) eine innere Wand aufweist, von der mindestens ein Abschnitt zylindrisch ist, und wobei das Verhältnis des Durchmessers der inneren Wand der Spindel (203) zum Durchmesser der Innenfläche (107) der Wand des Gehäuses (100) im Bereich des Zusammenwirkens zwischen der Spindel (203) und der Mutter (105) größer als 0,6 und bevorzugt größer als 0,85 ist.

5. Ventil (1) gemäß einem der vorstehenden Ansprüche, wobei das Zusammenwirken zwischen der Spindel (203) und der Mutter (105) eine Verbindung vom Typ Kugelumlaufspindel bildet und wobei bevorzugt die Kugelumlaufspindel so eingerichtet ist, dass sie nicht umkehrbar ist, derart, dass eine Druckkraft, die auf den Verschluss (201) ausgeübt wird mindestens in die Richtung, die dazu tendiert, den Verschluss (201) vom Sitz (104) zu entfernen, es nicht ermöglicht, die Spindel (203) in Drehung zu versetzen.

6. Ventil (1) gemäß einem der vorstehenden Ansprüche, wobei das Gehäuse (100) ein einstückiges Teil bildet und wobei bevorzugt das Gehäuse (100) und die Spindel (203) aus Metall sind.

7. Ventil (1) gemäß einem der vorstehenden Ansprüche, wobei der Verschluss (201) mindestens um die Translationsachse der Spindel (203) herum frei drehbar auf der Spindel (203) angelenkt ist.

8. Ventil (1) gemäß einem der vorstehenden Ansprüche, wobei die mechanische Verbindung zwischen einerseits dem Gehäuse (100) und andererseits der Spindel (203) ausschließlich durch das Zusammenwirken zwischen der Spindel (203) und der Mutter (105) sichergestellt wird.

9. Ventil (1) gemäß einem der vorstehenden Ansprüche, umfassend eine Ummantelung, die fest mit der Spindel (203) verbunden ist und mit der Spindel (203) zusammenwirkt, um eine dichte Aufnahme (207) zu bilden, die dazu bestimmt ist, den Anker (202) aufzunehmen.

10. Ventil (1) gemäß einem der Ansprüche 1 bis 8, wobei der Anker (202) und die Spindel (203) ein einstückiges Teil bilden.

11. Ventil (1) gemäß einem der vorstehenden Ansprüche, wobei sich das Gefäß (101) im Wesentlichen gemäß einer Längsrichtung (2) erstreckt, die der Translationsrichtung der Spindel (203) entspricht, und mindestens einer aus dem Einlass (102) und dem Auslass (103) derart ausgebildet ist, dass er einen Tiefpunkt des Gefäßes (101) mindestens für eine Stellung des Ventils (1) bildet, in der ihre Längsrichtung (2) horizontal angeordnet ist.

12. Ventil (1) gemäß einem der Ansprüche 1 bis 11, wobei sich das Gehäuse (100) im Wesentlichen gemäß einer Längsrichtung (2) erstreckt, die der Translationsrichtung der Spindel (203) entspricht, und mindestens einen aus dem Einlass (102) und dem Auslass (103) aufweist, der in Bezug auf die Translationsrichtung der Spindel (203) versetzt ist.

13. Ventil (1) gemäß einem der vorstehenden Ansprüche, wobei:
- die Steuervorrichtung Dauermagneten umfasst, und/oder
- die Steuervorrichtung Spulen umfasst, wobei der Induktor (113) bevorzugt in Bezug auf das Gehäuse (100) fest ist.

14. System zum Regeln des Kreislaufs eines flüssigen Metalls, umfassend eine metallische Rohrleitung und ein Ventil (1) gemäß einem der vorstehenden Ansprüche, wobei das Gehäuse (100) und die Spindel (203) aus Metall sind, wobei das Ventil (1) an die Rohrleitung geschweißt ist.

15. Verwendung des Ventils (1) gemäß einem der Ansprüche 1 bis 13, um den Kreislauf eines Fluids zu regeln, das eine Temperatur von größer oder gleich 350 °C, und bevorzugt von größer oder gleich 400 °C aufweist.

16. Verwendung des Ventils (1) gemäß dem vorstehenden Anspruch, um den Kreislauf von flüssigem Natrium zu steuern, das dazu bestimmt ist, die Wärmeübertragung in einem Kernreaktorkreislauf mit Natrium-Kühlmittel sicherzustellen.

## Claims

1. Valve (1) comprising:
- a case (100) forming a chamber (101) inside of which fluid is intended to circulate and having at least one inlet (102) and at least one outlet (103) of the fluid,
- a plug (201) configured to cooperate with a seat (104) rigidly connected to the case (100) in order to close at least the inlet (102) or at least the outlet (103) of the fluid,
- a device for controlling the position of the plug (201) with respect to the seat (104),
wherein:
- the control device comprises at least one inductor (113) and at least one armature (202) magnetically coupled and configured in order for the inductor (113) to drive the armature (202) in rotation in such a way as to selectively move the plug (201) closer to or farther away from the seat (104),
- the armature (202) is located inside the chamber (101) and is stationary with respect to a bolt (203) carrying the plug (201), the bolt (203) being configured to cooperate with a nut (105) rigidly connected to the case (100) in such a way as to transform a rotation of the armature (202) into a translation of the plug (201),
- the bolt (203) is hollow and
**characterised in that** the valve (1) is configured in such a way that the main flow of the fluid takes place through the inside of the bolt (203).

2. Valve (1) according to the previous claim, configured in such a way that all the fluid flows through the inside of the bolt (203).

3. Valve (1) according to any one of the previous claims, wherein the case (100) has a wall forming the chamber (101), wherein the inductor (113) and the armature (202) are positioned on either side of the wall, and wherein the nut (105) is carried by an inner face (107) of the wall.

4. Valve (1) according to any one of the previous claims, wherein the wall of the case (100) has an inner face (107), at least a portion of which is cylindrical, and the bolt (203) has an inner wall, at least a portion of which is cylindrical, and wherein the ratio of the diameter of the inner wall of the bolt (203) to the diameter of the inner face (107) of the wall of the case (100) at the location of the cooperation between the bolt (203) and the nut (105) is greater than 0.6 and preferably greater than 0.85.

5. Valve (1) according to any one of the previous claims, wherein the cooperation between the bolt (203) and the nut (105) forms a ball-screw link and wherein, preferably, the ball screw is configured to be irreversible, in such a way that a thrust force applied to the plug (201), at least in the direction tending to move the plug (201) away from the seat (104), does not allow the bolt (203) to be rotated.

6. Valve (1) according to any one of the previous claims, wherein the case (100) forms a one-piece part and wherein, preferably, the case (100) and the bolt (203) are made of metal.

7. Valve (1) according to any one of the previous claims, wherein the plug (201) is articulated on the bolt (203) in such a way as to freely rotate at least about the axis of translation of the bolt (203).

8. Valve (1) according to any one of the previous claims, wherein the mechanical link between the case (100) and the bolt (203) is provided only by the cooperation between the bolt (203) and the nut (105).

9. Valve (1) according to any one of the previous claims, comprising an envelope rigidly connected to the bolt (203) and cooperating with the bolt (203) in order to form an impermeable housing (207) intended to receive the armature (202).

10. Valve (1) according to any one of claims 1 to 8, wherein the armature (202) and the bolt (203) form a one-piece part.

11. Valve (1) according to any one of the previous claims, wherein the chamber (101) extends mainly in a longitudinal direction (2) corresponding to the direction of translation of the bolt (203) and at least one out of the inlet (102) and the outlet (103) is shaped in such a way as to form a low point of the chamber (101) at least for a position of the valve (1) in which its longitudinal direction (2) is positioned horizontally.

12. Valve (1) according to any one of claims 1 to 11, wherein the case (100) extends mainly in a longitudinal direction (2) corresponding to the direction of translation of the bolt (203) and at least one out of the inlet (102) and the outlet (103) of said case is not aligned with the direction of translation of the bolt (203).

13. Valve (1) according to any one of the previous claims, wherein:
- the control device comprises permanent magnets and/or
- the control device comprises coils, the armature (113) being, preferably, stationary with respect to the case (100).

14. System for regulating the circulation of a liquid metal, comprising a metal pipe and a valve (1) according to any one of the previous claims in which the case (100) and the bolt (203) are made of metal, the valve (1) being welded to the pipe.

15. Use of a valve (1) according to any one of claims 1 to 13 to regulate the circulation of a fluid having a temperature greater than or equal to 350°C and preferably greater than or equal to 400°C.

16. Use of a valve (1) according to the previous claim to control the circulation of liquid sodium intended to carry out the transfer of heat in a circuit of a nuclear reactor having a sodium heat transfer fluid.
